# EUROPEAN PATENT SPECIFICATION

(11) **EP 3 477 310 B1**
(45) Date of publication and mention of the grant of the patent: **08.06.2022**
(21) Application number: 17815049.6
(22) Date of filing: 11.05.2017
(51) Int. Cl.: G01R 15/16, G01R 15/06, H02B 13/035, H02B 13/065

(54) **VOLTAGE DETECTION DEVICE AND GAS INSULATION SWITCHGEAR APPARATUS HAVING VOLTAGE DETECTION DEVICE MOUNTED THEREON**
SPANNUNGSDETEKTOR UND GASISOLIERTE SCHALTANLAGE MIT DARAN MONTIERTEM SPANNUNGSDETEKTOR
DISPOSITIF DE DÉTECTION DE TENSION ET APPAREIL DE COMMUTATION À ISOLATION GAZEUSE COMPORTANT UN DISPOSITIF DE DÉTECTION DE TENSION MONTÉ SUR CE DERNIER

(30) Priority: 23.06.2016 JP 2016124156
(43) Date of publication of application: 01.05.2019
(73) Proprietor: Mitsubishi Electric Corporation, Chiyoda-ku Tokyo 100-8310 (JP)
(72) Inventor: YAMAJI Yuichi, Tokyo 100-8310 (JP); KURODA Takashi, Tokyo 100-8310 (JP); EBATO Teruaki, Tokyo 100-8310 (JP); KUROAKI Shintarou, Tokyo 102-0073 (JP); FUJI Kenichi, Tokyo 102-0073 (JP)
(74) Representative: Mewburn Ellis LLP
(86) International application number: PCT/JP2017/017895
(87) International publication number: WO 2017/221579

(56) References cited:
- EP-A2- 1 202 417
- EP-A2- 2 073 331
- DE-A1- 2 313 401
- DE-A1-102013 219 268
- DE-A1-102014 004 284
- DE-U1-202011 051 745
- JP-A- H0 767 238
- JP-A- H1 021 768
- JP-A- H04 504 164
- JP-A- 2002 025 372
- JP-A- 2003 337 144
- JP-A- 2007 244 099
- JP-A- 2015 042 069
- JP-U- S6 267 275
- JP-U- S63 118 575
- US-A- 3 942 099

## Description

### TECHNICAL FIELD

The present invention relates to a voltage detection device for use in, for example, a gas insulated switchgear and a gas insulated switchgear equipped with the voltage detection device.

### BACKGROUND ART

A gas insulated switchgear disposes: power switching apparatuses such as a circuit breaker, a disconnecting switch, and a grounding switch; and main circuit conductors that connect the respective apparatuses to form electrical paths, in a grounded metallic tank. A bushing is disposed on an arbitrary surface of the metallic tank to connect the electrical paths inside the metallic tank to busbars or external power cables outside the metallic tank.

The bushing such as this is provided with a groove in which a seal member such as an O-ring is placed and thus the seal can be kept. The busbar is connected to the bushing placed one side and the external power cable is connected to another bushing placed the other side.

Furthermore, the power switching apparatuses such as the circuit breaker, the disconnecting switch, and the earthing switch perform opening/closing operation using an operating mechanism, a rod, and a link, which are placed outside the metallic tank; and accordingly, a portion through which an operating shaft passes the metallic tank is provided with a seal portion and the seal of the metallic tank is secured.

The metallic tank is filled with insulating gas such as hexafluoride (SF6) gas and dry air at a predetermined pressure to reduce insulation distances between phases of charged portions and between the charged portion and the tank and to achieve a reduction in size of the device.

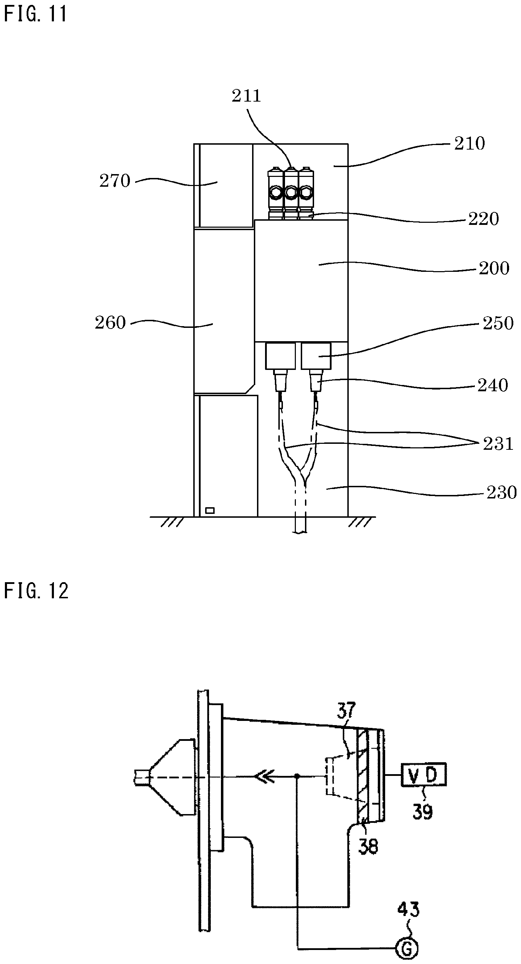

There is one in which a cable head shown in FIG. 12 is utilized for a voltage detection device in a conventional gas insulated switchgear. The surface of the cable head is provided with a ground layer, a part of the ground layer on the surface of the cable head is peeled off, a capacitor is formed by the insulation plug itself behind the cable head, and a voltage divided by the insulation plug is detected by a voltage detection device connected to the insulation plug. (See Patent Document 1.)

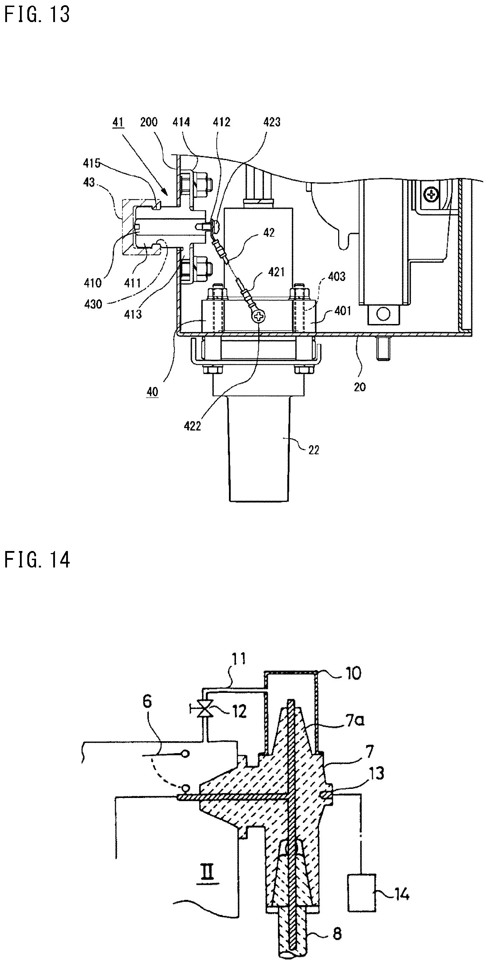

There is also one in which a voltage detector is equipped in a metallic tank as shown in FIG. 13. The voltage detector is provided with a groove in which a seal member such as an O-ring is placed to keep the seal of the tank. On the other hand, a sensor electrode is embedded inside an insulator arranged in a main circuit portion and the sensor electrode is connected to the voltage detector by an electrical wire and a voltage induced in the sensor electrode is detected by the voltage detector. (See Patent Document 2.)

Furthermore, there is also one in which an embedded metal is provided in a cable head as shown in FIG. 14, the embedded metal is insulated from a ground layer on the surface of the cable head and is connected to a voltage detector, thereby detecting a voltage applied to the cable head by the voltage detector. (See Patent Document 3.)

### PRIOR ART DOCUMENT

### PATENT DOCUMENT

Patent Document 1: JP,3537985,B
Patent Document 2: JP,2007-244099,A
Patent Document 3: JP,S62(1987)-244205,A
Patent Document 4: US 3942099A discloses measuring transformer with a capacitor bushing
Patent Document 5: DE 10 2013 219268A1 discloses solid insulated busbar

### SUMMARY OF THE INVENTION

### PROBLEMS TO BE SOLVED BY THE INVENTION

In the aforementioned conventional gas insulated switchgear, there is a case where an interface portion with the external power cable is interfaced in the air. For example, that case is equivalent to a case where the existing and used external power cable is applied when the existing gas insulated switchgear is replaced. At that time, problems exist in that since the cable head is not used, a voltage of a main circuit cannot be detected by the insulation plug itself by cutting off the ground layer on the surface of the cable head; and, since the cable head in which the embedded metal is embedded cannot be used, the voltage of the main circuit cannot be detected by utilizing the embedded metal of the cable head.

Furthermore, if the voltage detection device is fixed in the tank of the gas insulated switchgear, a space which is for mounting the voltage detection device is required in the tank and it causes one of obstructive factors for a reduction in size of the tank and a reduction in size of the whole gas insulated switchgear.

Moreover, in the case of placing the voltage detection device in the tank, a gas seal portion is required; and accordingly, a problem exists in that it leads to increase a portion where gas leakage possibly occurs.

The present invention has been made to solve the above described problem, and an object of the present invention is to provide a voltage detection device and a gas insulated switchgear equipped with the voltage detection device, which can easily detect a voltage of a main circuit conductor by arranging an antenna on the surface of a bushing to which an external power cable is connected.

### MEANS FOR SOLVING THE PROBLEMS

According to the present invention, there is provided a voltage detection device as set forth in claim 1.

Furthermore, according to the present invention, there is provided a gas insulated switchgear as set forth in claim 6.

### ADVANTAGEOUS EFFECT OF THE INVENTION

According to a voltage detection device according to the present invention, a conductive layer to be connected to a tank is provided on the surface of a bushing, a part of the conductive layer is cut off, an antenna that detects a voltage applied to a center conductor is arranged on a portion of the cut-off conductive layer, and a voltage detector arranged outside the tank is connected to the antenna, whereby there can be obtained a voltage detection device that can easily detect a voltage of a main circuit conductor.

### BRIEF DESCRIPTION OF THE DRAWINGS

FIG. 1 is a side sectional view showing a gas insulated switchgear equipped with a voltage detection device according to Embodiment 1 of the present invention;
FIG. 2 is a front view showing a bushing in the voltage detection device according to Embodiment 1 of the present invention;
FIG. 3 is a side sectional view showing the voltage detection device according to Embodiment 1 of the present invention;
FIG. 4 is a front view showing an antenna in the voltage detection device according to Embodiment 1 of the present invention;
FIG. 5 is a side view showing the antenna in the voltage detection device according to Embodiment 1 of the present invention;
FIG. 6 is a side sectional view showing a voltage detection device according to Embodiment 2 of the present invention;
FIG. 7 is a front view showing an antenna in the voltage detection device according to Embodiment 2 of the present invention;
FIG. 8 is a side view showing the antenna in the voltage detection device according to Embodiment 2 of the present invention;
FIG. 9 is a side sectional view showing a voltage detection device according to Embodiment 3 of the present invention;
FIG. 10 is a side sectional view showing a relevant part of the voltage detection device according to Embodiment 3 of the present invention;
FIG. 11 is a side sectional view showing a gas insulated switchgear equipped with a voltage detection device according to Embodiment 4 of the present invention;
FIG. 12 is a sectional view showing a cable head in a conventional gas insulated switchgear;
FIG. 13 is a sectional view showing a state where a conventional voltage detection device is equipped in a gas insulated switchgear; and
FIG. 14 is a sectional view showing a cable head in other conventional gas insulated switchgear.

### MODE FOR CARRYING OUT THE INVENTION

### Embodiment 1.

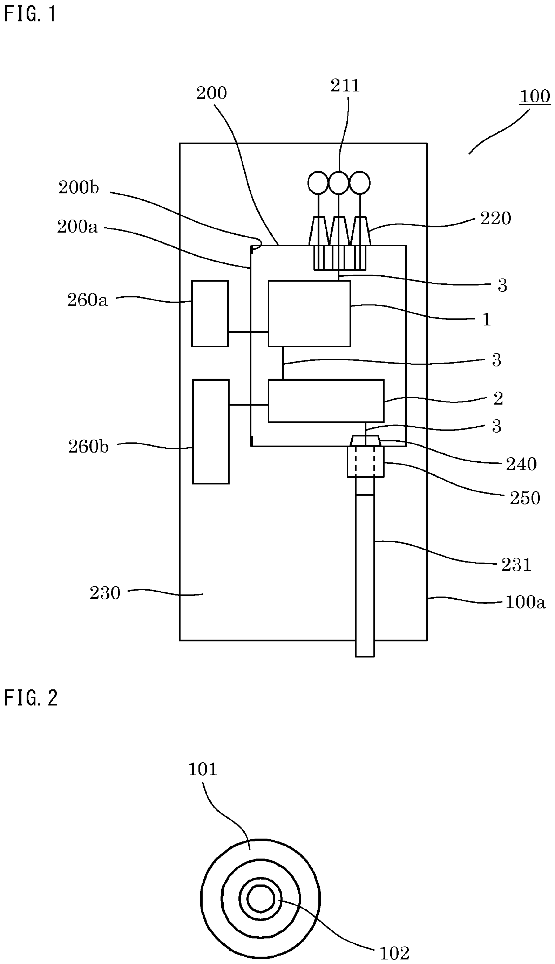

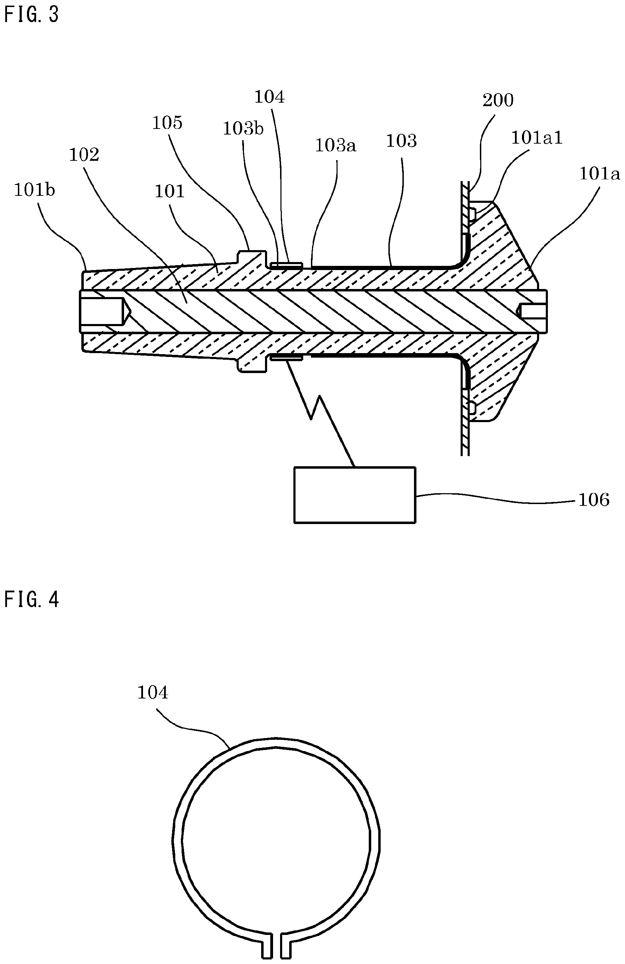

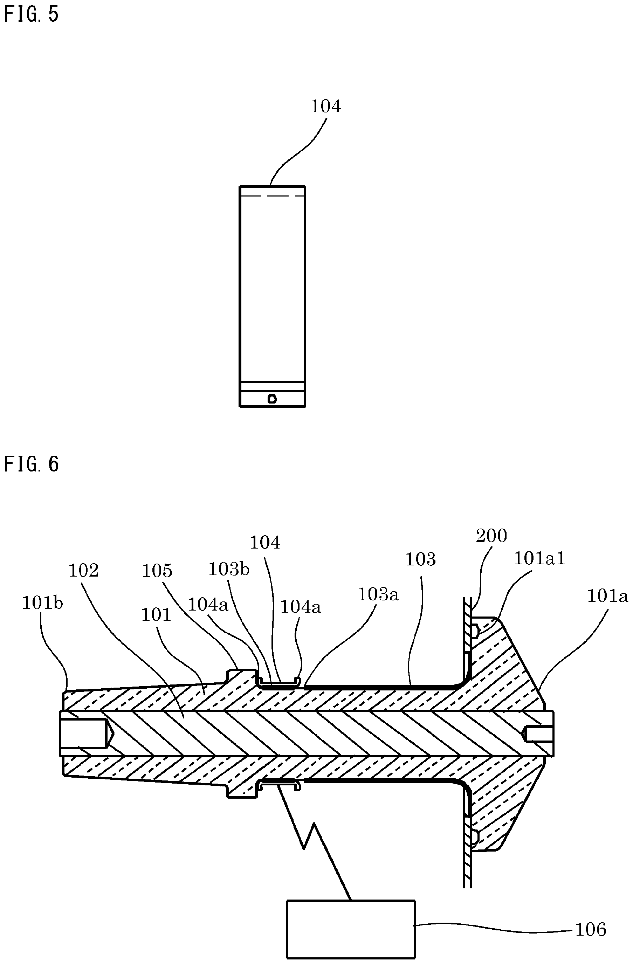

Hereinafter, Embodiment 1 of the present invention will be described on the basis of FIG. 1 to FIG. 5. Then, in each of the drawings, identical or equivalent members and portions will be described with the same reference numerals (and letters) assigned thereto. FIG. 1 is a side sectional view showing a gas insulated switchgear equipped with a voltage detection device according to Embodiment 1 of the present invention. FIG. 2 is a front view showing a bushing in the voltage detection device according to Embodiment 1 of the present invention. FIG. 3 is a side sectional view showing the voltage detection device according to Embodiment 1 of the present invention. FIG. 4 is a front view showing an antenna in the voltage detection device according to Embodiment 1 of the present invention. FIG. 5 is a side view showing the antenna in the voltage detection device according to Embodiment 1 of the present invention.

FIG. 1 is a side sectional view exemplarily showing the configuration of a gas insulated switchgear 100 equipped with the voltage detection device according to Embodiment 1 of the present invention. A tank 200 is arranged near the vertical center of the gas insulated switchgear 100; and main circuit apparatuses such as a disconnecting switch 1 and a circuit breaker 2 are placed inside the tank 200.

Each of the main circuit apparatuses is connected by a main circuit conductor 3 in the tank 200 to form an electrical path. Insulating gas such as SF6 gas and dry air is pressurized to a necessary pressure and is filled in the tank 200.

A busbar 211 that connects between mutual adjacent gas insulated switchgears is arranged above the tank 200; and a bushing 220 that connects the busbar 211 and the inside of the tank 200 is arranged. The bushing 220 performs gas seal of the inside and the outside of the tank 200 by inserting a seal member (not shown in the drawing) such as an O-ring into a joint portion of a pass-through portion of the tank 200.

On the other hand, a cable compartment 230 is arranged below the tank 200, an external power cable 231 is led to the inside of a panel 100a that surrounds the outer periphery of the gas insulated switchgear 100, and a bushing 240 is arranged to connect the external power cable 231 to the main circuit conductor 3 in the inside of the tank 200. The bushing 240 also performs gas seal of the inside and the outside of the tank 200 by inserting the seal member (not shown in the drawing) such as the O-ring into a joint portion of a pass-through portion of the tank 200 as in the busbar 211 side.

Furthermore, an instrument current transformer (CT) 250 is arranged in a state where the bushing 240 passes therethrough on the outside of the tank 200 to detect a current that flows through a center conductor 102 of the bushing 240, that is, to detect the current that flows through the external power cable 231.

Further, a disconnecting switch operating mechanism 260a that operates the disconnecting switch 1 and a circuit breaker operating mechanism 260b that operates the circuit breaker 2 are arranged in an aperture portion on the front side of the tank 200, the disconnecting switch 1 and the circuit breaker 2 being placed inside the tank 200. The disconnecting switch operating mechanism 260a and the circuit breaker operating mechanism 260b are fixed and retained by a mounting plate 200a attached to a flange 200b that is formed in a frame shape around the aperture portion on the front side of the tank 200. Then, a sealed state of the aperture portion on the front side of the tank 200 is secured by a seal portion (not shown in the drawing) applied on a joint portion between the mounting plate 200a and an outer peripheral frame-shaped portion (not shown in the drawing) of the aperture portion on the front side of the tank 200, the outer peripheral frame-shaped portion being the flange 200b.

In FIG. 2 to FIG. 5, a bushing 101 is made of: thermosetting resins such as epoxy resin, phenol resin, and thermosetting polyester; thermoplastic resins such as polyethylene and polypropylene; and rubbers such as ethylene-propylene copolymerization rubber and ethylene-propylene-diene ternary copolymerization rubber.

The center conductor 102 which is to be connected to the main circuit conductor 3 (not shown in the drawing) arranged in the tank 200 of the gas insulated switchgear is molded in a center portion of the bushing 101. A specified shape is formed in a tip portion of the external power cable connection portion 101b on one side of the bushing 101 so that a cable head (not shown in the drawing) can be connected thereto.

A specified shape is formed in a main circuit conductor connection portion 101a which is to be connected to the main circuit conductor of the gas insulated switchgear on the other side of the external power cable connection portion 101b so that the main circuit conductor can be connected thereto.

A protrusion surface on the main circuit conductor connection portion 101a side is provided with an embedded metal (not shown in the drawing) so that the protrusion surface can be fixed to the tank 200 of the gas insulated switchgear and is formed with a groove 101a1 in which a seal member such as an O-ring is placed to seal the tank 200.

The surface of the bushing 101 is provided with a conductive layer 103 which is constituted by, for example, a conductive coating material layer applied with conductive coating material or the like, a thermal spraying layer of aluminum, a plating layer of conductive metal such as copper and nickel, a conductive rubber layer, and the like; and the conductive layer 103 is directly connected to, for example, the tank 200 serving as a ground portion to ground the conductive layer 103 on the surface of the bushing 101.

For example, a ring-shaped antenna 104 is attached to a portion of a cut-off conductive layer 103b in which a part of the conductive layer 103 is cut off. More specifically, the antenna 104 is attached to the cut-off conductive layer 103b which is present on the surface of the bushing 101 between, for example, a ring-shaped projection portion 105 provided on a central portion of the bushing 101 and an end portion 103a of the conductive layer 103. As described above, a portion to be separated from the conductive layer 103 grounded to the tank 200 can be defined; and an effect exists in that an increase in electric field of the end portion 103a of the conductive layer 103 is suppressed.

A voltage detector 106 arranged outside the tank 200 receives a signal from the antenna 104 attached to the cut-off conductive layer 103b and detects a voltage applied to the center conductor 102 placed on the center portion of the bushing 101.

As described above, the ring-shaped antenna 104 is arranged on the outer periphery of the portion of the cut-off conductive layer 103b, whereby the antenna 104 can be easily attached even in the case of connecting by, for example, a compression terminal for use in an air insulated switchgear regardless of the presence or absence of the cable head of the external power cable and the voltage applied to the center conductor 102 that is present on the center portion of the bushing 101 connected to the main circuit conductor can be easily detected. Furthermore, the antenna 104 is fixed to the bushing 101, whereby an extra gas seal portion does not need to be provided on the tank 200 side and a portion where gas leakage possibly occurs does not need to be increased. Then, since the voltage detector 106 does not need to be placed in the tank 200, a reduction in size of the tank 200 is achieved.

### Embodiment 2.

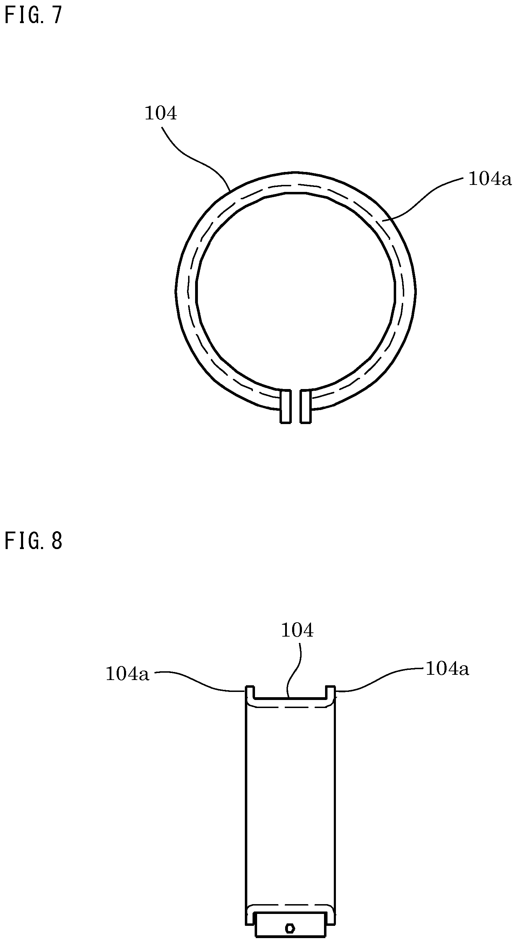

Embodiment 2 of the present invention will be described on the basis of FIG. 6 to FIG. 8. Then, in each of the drawings, identical or equivalent members and portions will be described with the same reference numerals (and letters) assigned thereto. FIG. 6 is a side sectional view showing a voltage detection device according to Embodiment 2 of the present invention. FIG. 7 is a front view showing an antenna in the voltage detection device according to Embodiment 2 of the present invention. FIG. 8 is a side view showing the antenna in the voltage detection device according to Embodiment 2 of the present invention.

The configuration of a bushing 101 is the same as that of the aforementioned Embodiment 1. An end portion 103a of a conductive layer 103 applied on the surface of the bushing 101 is formed in an edge shape; and if a voltage is applied to a center conductor 102 that is present in a center portion of the bushing 101, an electric field of the end portion 103 of the conductive layer 103 is increased. A partial discharge occurs from the end portion 103a of the conductive layer 103 and then reaches a flashover; and accordingly, there is a case where required insulation performance is not satisfied.

In this Embodiment 2, as shown in FIG. 6, both end portions of an antenna 104, which is attached to a cut-off conductive layer 103b that is present on the surface of the bushing 101 between a projection portion 105 provided on a central portion of the bushing 101 and the end portion 103a of the conductive layer 103, are provided with protrusion portions 104a bent in directions leaving from the center conductor 102.

In this Embodiment 2, both end portions of the antenna 104 are formed into the protrusion portions 104a bent in the directions leaving from the center conductor 102, whereby the same effect as that of the aforementioned Embodiment 1 can be obtained; and in addition to that, an increase in electric field at the end portion 103a of the conductive layer 103 can be more suppressed and insulation performance can be satisfied.

Incidentally, the protrusion portions 104a of the antenna 104, which are bent in the directions leaving from the center conductor 102, are not necessarily provided on both end portions, but, if the protrusion portion 104a is provided at least either end portion of the antenna 104, an expected effect can be obtained.

### Embodiment 3.

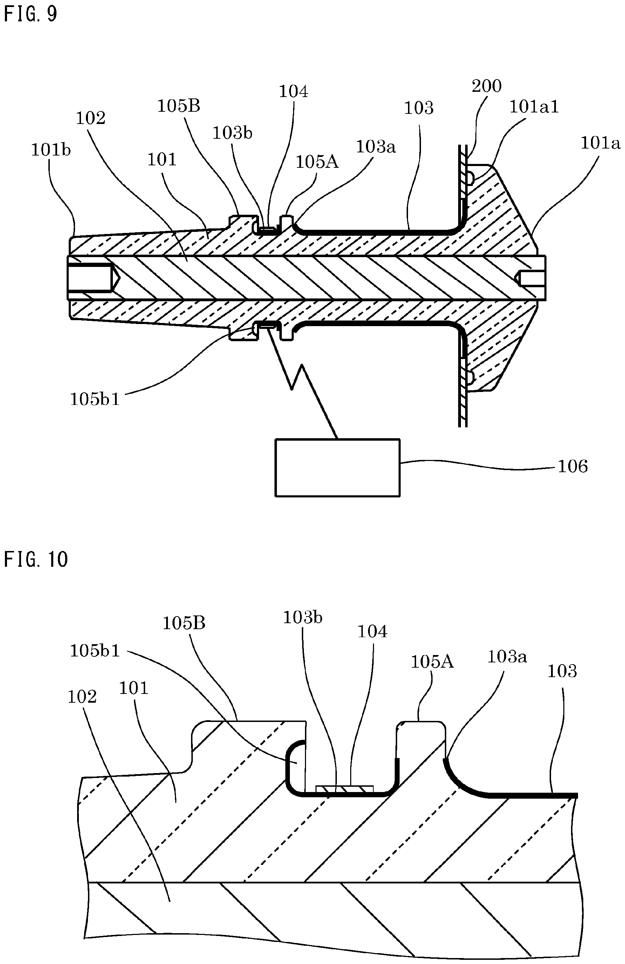

Embodiment 3 of the present invention will be described on the basis of FIG. 9 and FIG. 10. Then, in each of the drawings, identical or equivalent members and portions will be described with the same reference numerals (and letters) assigned thereto. FIG. 9 is a side sectional view showing a voltage detection device according to Embodiment 3 of the present invention. FIG. 10 is a side sectional view showing a relevant part of the voltage detection device according to Embodiment 3 of the present invention.

The configuration of a bushing 101 is the same as that of the aforementioned Embodiment 1. Embodiment 3 of the present invention shows a case where ring-shaped projection portions 105A, 105B are provided on a central portion of the bushing 101. One side projection portion 105A is provided at a portion where a conductive layer 103 grounded to a tank 200 is cut off. The other side projection portion 105B is provided nearer to the external power cable connection portion 101b side than the projection portion 105A; and the inner shape of the projection portion 105B is formed into, for example, an round portion 105b1 as shown in FIG. 10. Then, an antenna 104 is arranged on a cut-off conductive layer 103b that is present between two projection portions of the projection portion 105A and the projection portion 105B.

One side projection portion 105A of the bushing 101 can define a portion that is cut off from the conductive layer 103 grounded to the tank 200 and has an effect in which an increase in electric field of an end portion 103a of the cut-off conductive layer 103 is suppressed. The inside shape of the other side projection portion 105B is formed into the round portion 105b1 as shown in FIG. 10, whereby the conductive layer 103b is extended also to the round portion 105b1 and a shape of suppressing an electric field can be constituted by the cut-off conductive layer 103b.

Therefore, in addition to the effects of the aforementioned Embodiment 1 and Embodiment 2, since the antenna 104 is arranged between two projection portions of the projection portion 105A and the projection portion 105B, a position where the antenna 104 is fixed is defined, the shape of the antenna 104 can also be formed into a simple ring shape like the one shown in FIG. 4 and FIG. 5 of Embodiment 1, and a stabilization of quality can be achieved.

### Embodiment 4.

Embodiment 4 of the present invention will be described on the basis of FIG. 11. Then, in each of the drawings, identical or equivalent members and portions will be described with the same reference numerals (and letters) assigned thereto. FIG. 11 is a side sectional view showing a gas insulated switchgear equipped with a voltage detection device according to Embodiment 4 of the present invention.

A tank 200 is arranged near the center of the gas insulated switchgear. Although not shown in the drawing, main circuit apparatuses such as a circuit breaker and a disconnecting switch are placed inside the tank 200 and each of the apparatuses is connected by a conductor to form an electrical path. Insulating gas such as SF6 gas and dry air is pressurized to a necessary pressure and is sealed in the tank 200.

Above the tank 200, a busbar 211 that connects between mutual adjacent gas insulated switchgears is arranged in a busbar compartment 210; and a bushing 220 that connects the busbar 211 and the inside of the tank 200 is arranged. The bushing 220 is provided with a seal portion (not shown in the drawing) to seal the insulating gas in the tank 200.

On the other hand, a cable compartment 230 is arranged below the tank 200, an external power cable 231 is led to the inside of a panel of the gas insulated switchgear, and a bushing 240 is arranged to connect the external power cable 231 and the inside of the tank 200. The bushing 240 also has a seal portion (not shown in the drawing) similarly to the busbar side and the insulating gas is sealed.

Furthermore, the bushing 240 is formed into various shapes, such as an L-shape and a T-shape without sticking to a linear shape. An instrument current transformer 250 is arranged at the base of the bushing 240 and detects a current that passes from the busbar 211 to the tank 200 and flows into the external power cable 231.

A flange (not shown in the drawing) to which an operating mechanism 260 which is for operating the apparatuses placed inside the tank 200, for example, the circuit breaker and the disconnecting switch, is fixed is provided on the front of the tank 200; and the seal of the front side of the tank 200 is secured by a seal portion (not shown in the drawing) applied on the surface of the flange. Furthermore, a control compartment 270 is arranged above the operating mechanism 260.

A pressure relief plate (not shown in the drawing), which is for suppressing an increased pressure when a fault occurs in the tank 200 in the worst case, is provided on the rear of the tank 200. The seal of the pressure relief plate is also secured by a seal portion (not shown in the drawing).

The bushing 240 in the gas insulated switchgear is equipped with the antenna 104 and the voltage detector 106 of any of the aforementioned Embodiment 1 to Embodiment 3. At that time, the antenna 104 is not equipped on the bushing 240 for one phase, but the antenna 104 is equipped on each of the bushings 240 for three phases.

The antenna 104 is equipped on the bushing 240 and the voltage detector 106 is connected, whereby a reduction in size of the tank and a reduction in size of the whole gas insulated switchgear can be achieved.

### INDUSTRIAL APPLICABILITY

The present invention is suitable for actualizing a voltage detection device that can easily detect a voltage of a main circuit conductor.

### DESCRIPTION OF REFERENCE NUMERALS

1 Disconnecting switch, 2 Circuit breaker, 3 Main circuit conductor, 100 Gas insulated switchgear, 101 Bushing, 101a Main circuit conductor connection portion, 101b External power cable connection portion, 102 Center conductor, 103 Conductive layer, 103a End portion, 103b Conductive layer, 104 Antenna, 104a Protrusion portion, 105 Projection portion, 105A Projection portion, 105B Projection portion, 105b1 Round portion, 106 Voltage detector, 200 Tank, 211 Busbar, 220 Bushing, 230 Cable compartment, 231 External power cable, 240 Bushing, 250 Instrument current transformer, 260 Operating mechanism, 260a Disconnecting switch operating mechanism, 260b Circuit breaker operating mechanism, and 270 Control compartment.

## Claims

1. A voltage detection device comprising:
a bushing (101) which is composed of an external power cable connection portion (101b) configured to be connected to an external power cable and a main circuit conductor connection portion configured to be connected (231) to a main circuit conductor (3) arranged in a tank (200), and whose center portion has a center conductor (102) configured to be connected to the main circuit conductor (3);
a conductive layer (103) which is provided on a surface of said bushing (101) and is configured to be connected to the tank (200) to be set to ground potential;
a separate conductive layer (103b) portion on the surface of the bushing, the separate conductive layer (103b) portion being separated from the conductive layer (103) and being configured to be set to intermediate potential;
a ring-shaped antenna (104) which is arranged on said separate conductive layer (103b) portion and is configured to detect a voltage applied to the center conductor (102); and
a voltage detector (106) which is configured to be arranged outside the tank (200) and is connected to said antenna (104).

2. The voltage detection device according to claim 1,
wherein said bushing (101) is provided with a projection portion (105) at a central portion thereof; and
said antenna (104) is arranged on said separate conductive layer (103b) portion between the projection portion (105) and an end portion of said conductive layer (103).

3. The voltage detection device according to claim 1 or claim 2,
wherein an end portion of said antenna (104) is formed into a protrusion portion (104a) bent in a direction leaving from the center conductor (102).

4. The voltage detection device according to claim 1,
wherein said bushing (101) is provided with two projection portions (105A,105B) at a central portion thereof; and
said antenna (104) is arranged on said separate conductive layer (103b) portion between the two projection portions (105A,105B).

5. The voltage detection device according to claim 4,
wherein an inner side of the projection portion (105B) located on the main circuit conductor connection portion (101b) side is formed into an round portion (105b1); and
said separate conductive layer (103b) portion is arranged on a portion of the round portion (105b1).

6. A gas insulated switchgear, comprising:
a main circuit conductor configured to be connected to a main circuit apparatus such as a circuit breaker and a disconnecting switch;
a bushing (220) arranged on an upper portion of a tank (200) in which said main circuit conductor and insulating gas are sealed together;
a busbar (211) configured to be connected to said main circuit conductor via said bushing (220); and
a bushing (240) arranged on a lower portion or side portion of the tank (200),
wherein a voltage detection device as set forth in any one of claim 1 to claim 5 is equipped.

## Patentansprüche

1. Spannungsdetektionsvorrichtung, umfassend:
eine Buchse (101), die aus einem externen Leistungskabelverbindungsabschnitt (101b), der konfiguriert ist, um mit einem externen Leistungskabel verbunden zu werden, und einem Hauptstromkreisleiterverbindungsabschnitt, der konfiguriert ist, um mit einem Hauptstromkreisleiter (3) verbunden zu werden (231), der in einem Tank (200) angeordnet ist, besteht, und dessen zentraler Abschnitt einen zentralen Leiter (102) aufweist, der konfiguriert ist, um mit dem Hauptstromkreisleiter (3) verbunden zu werden;
eine Leitungsschicht (103), die auf einer Oberfläche der Buchse (101) bereitgestellt ist und konfiguriert ist, um mit dem Tank (200) verbunden zu werden, der auf Massepotential zu legen ist;
einen separaten Leitungsschichtabschnitt (103b) auf der Oberfläche der Buchse, wobei der separate Leitungsschichtabschnitt (103b) von der Leitungsschicht (103) getrennt ist und konfiguriert ist, um auf ein Zwischenpotential gelegt zu werden;
eine ringförmige Antenne (104), die auf dem separaten Leitungsschichtabschnitt (103b) angeordnet ist und konfiguriert ist, um eine Spannung zu detektieren, die auf den zentralen Leiter (102) angelegt wird, und
einen Spannungsdetektor (106), der konfiguriert ist, um außerhalb des Tanks (200) angeordnet zu werden und mit der Antenne (104) verbunden ist.

2. Spannungsdetektionsvorrichtung nach Anspruch 1,
wobei die Buchse (101) an einem zentralen Abschnitt derselben mit einem Vorsprungsabschnitt (105) versehen ist; und
die Antenne (104) auf dem separaten Leitungsschichtabschnitt (103b) zwischen dem Vorsprungsabschnitt (105) und einem Endabschnitt der Leitungsschicht (103) angeordnet ist.

3. Spannungsdetektionsvorrichtung nach Anspruch 1 oder Anspruch 2,
wobei ein Endabschnitt der Antenne (104) zu einem Vorsprungsabschnitt (104a) geformt ist, der in einer Richtung weg vom zentralen Leiter (102) gebogen ist.

4. Spannungsdetektionsvorrichtung nach Anspruch 1,
wobei die Buchse (101) mit zwei Vorsprungsabschnitten (105A, 105B) an einem zentralen Abschnitt derselben versehen ist; und
die Antenne (104) auf dem separaten Leitungsschichtabschnitt (103b) zwischen den zwei Vorsprungsabschnitten (105A, 105B) angeordnet ist.

5. Spannungsdetektionsvorrichtung nach Anspruch 4,
wobei eine Innenseite des Vorsprungsabschnitts (105B), der sich auf der Seite des Hauptstromkreisleiterverbindungsabschnitts (101b) befindet, zu einem runden Abschnitt (105b1) geformt ist; und
der separate Leitungsschichtabschnitt (103b) auf einem Abschnitt des runden Abschnitts (105b1) angeordnet ist.

6. Gasisolierte Schaltanlage, umfassend:
einen Hauptstromkreisleiter, der konfiguriert ist, um mit einer Hauptstromkreisvorrichtung, wie z. B. einem Schutzschalter und einem Trennschalter, verbunden zu werden;
eine Buchse (220), die auf einem oberen Abschnitt eines Tanks (200) angeordnet ist, in dem der Hauptstromkreisleiter und Isoliergas zusammen abgedichtet sind;
eine Sammelschiene (211), die konfiguriert ist, um mit dem Hauptstromkreisleiter über die Buchse (220) verbunden zu werden; und
eine Buchse (240), die auf einem unteren Abschnitt oder Seitenabschnitt des Tanks (200) angeordnet ist,
wobei eine Spannungsdetektionsvorrichtung nach einem der Ansprüche 1 bis 5 ausgestattet ist.

## Revendications

1. Dispositif de détection de tension comprenant :
une traversée (101) qui est composée d'une partie de connexion de câble d'alimentation externe (101b) configurée pour être connectée à un câble d'alimentation externe et une partie de connexion de conducteur de circuit principal configurée pour être connectée (231) à un conducteur de circuit principal (3) agencé dans un réservoir (200), et dont la partie centrale présente un conducteur central (102) configuré pour être connecté au conducteur de circuit principal (3) ;
une couche conductrice (103) qui est prévue sur une surface de ladite traversée (101) et est configurée pour être connectée au réservoir (200) pour être réglée à un potentiel de terre ;
une partie de couche conductrice séparée (103b) sur la surface de la traversée, la partie de couche conductrice séparée (103b) étant séparée de la couche conductrice (103) et étant configurée pour être réglée à un potentiel intermédiaire ;
une antenne en forme d'anneau (104) qui est agencée sur ladite partie de couche conductrice séparée (103b) et est configurée pour détecter une tension appliquée au conducteur central (102) ; et
un détecteur de tension (106) qui est configuré pour être disposé à l'extérieur du réservoir (200) et est connecté à ladite antenne (104).

2. Dispositif de détection de tension selon la revendication 1,
dans lequel ladite traversée (101) est pourvue d'une partie en saillie (105) au niveau d'une partie centrale de celle-ci ; et
ladite antenne (104) est agencée sur ladite partie de couche conductrice séparée (103b) entre la partie en saillie (105) et une partie d'extrémité de ladite couche conductrice (103) .

3. Dispositif de détection de tension selon la revendication 1 ou la revendication 2,
dans lequel une partie d'extrémité de ladite antenne (104) est formée en une partie de protubérance (104a) incurvée dans une direction partant du conducteur central (102).

4. Dispositif de détection de tension selon la revendication 1,
dans lequel ladite traversée (101) est pourvue de deux parties en saillie (105A, 105B) au niveau d'une partie centrale de celle-ci ; et
ladite antenne (104) est agencée sur ladite partie de couche conductrice séparée (103b) entre les deux parties en saillie (105A, 105B).

5. Dispositif de détection de tension selon la revendication 4,
dans lequel un côté intérieur de la partie en saillie (105B) située sur le côté de la partie de connexion de conducteur de circuit principal (101b) est formé en une partie ronde (105b1) ; et
ladite partie de couche conductrice séparée (103b) est agencée sur une partie de la partie ronde (105b1).

6. Appareillage de commutation à isolation gazeuse, comprenant :
un conducteur de circuit principal configuré pour être connecté à un appareil de circuit principal tel qu'un disjoncteur et un commutateur de déconnexion ;
une traversée (220) agencée sur une partie supérieure d'un réservoir (200) dans lequel ledit conducteur de circuit principal et ledit gaz isolant sont scellés ensemble ;
une barre omnibus (211) configurée pour être connectée audit conducteur de circuit principal via ladite traversée (220) ; et
une traversée (240) disposée sur une partie inférieure ou une partie latérale du réservoir (200),
dans lequel un dispositif de détection de tension selon l'une quelconque des revendications 1 à 5 est fourni.
